# EUROPEAN PATENT SPECIFICATION

(11) **EP 0 468 482 B1**
(45) Date of publication and mention of the grant of the patent: **03.05.1995**
(21) Application number: 91112430.3
(22) Date of filing: 24.07.1991
(51) Int. Cl.: H01S 3/085

(54) **Semiconductor laser**
Halbleiterlaser
Laser en semi-conducteur

(30) Priority: 25.07.1990 JP 194984/90
(43) Date of publication of application: 29.01.1992
(73) Proprietor: KABUSHIKI KAISHA TOSHIBA, Kawasaki-shi, Kanagawa-ken 210 (JP)
(72) Inventor: Kinoshita, Junichi, c/o Intellectual Property Div., Minato-ku, Tokyo 105 (JP)
(74) Representative: Lehn, Werner, Dipl.-Ing.

(56) References cited:
- EP-A- 0 214 866
- US-A- 4 282 494
- PATENT ABSTRACTS OF JAPAN vol. 5, no. 30 (E-47)24 February 1981;& JP-A-55156381
- IEEE JOURNAL OF QUANTUM ELECTRONICS. vol. QE-23, no. 6, June 1987, New York,US; pages 804-814; H.SODA et al.: "Stability in single longitudinal mode operation in GaInAsP/InP phase adjusted dfb lasers"
- ELECTRONICS LETTERS. vol. 24, no. 10, 12 May 1988, Stevenage, Herts, GB;pages 623 - 624; Y UENISHI et al.:"Beam converging laser diode by taper ridge waveguide"

## Description

The present invention relates to a semiconductor laser having a double heterostructure and, more particularly, to a distributed feedback (DFB) semiconductor laser in which a diffraction grating formed along a optical waveguide produces optical feedback.

Various types of semiconductor lasers have recently been used as light sources for optical communication and optical information processing. One of the semiconductor lasers is a distributed feedback (DFB) semiconductor laser having a diffraction grating along its optical waveguide. As been derived using coupled-mode analysis, the DFB laser oscillates at a single wavelength (in a single longitudinal mode) because of wavelength selectivity of the grating. The DFB laser is particularly improved in practicability by using GaInAsP/InP material system for a light source for long-distance high-speed optical communication.

In a conventional semiconductor laser, such as a FabryPerot (FP) type semiconductor laser, optical feedback is produced by both facets of the laser which serve as reflecting mirrors. In contrast, optical feedback in the DFB semiconductor laser is produced mainly by the diffraction grating having wavelength selectivity, so that principally the facets are not necessary. In the DFB semiconductor laser, however, a single longitudinal mode capability depends upon a shape and height of the diffraction grating, the reflectivity at the facets which are inevitably formed, and the phase of the diffraction grating at the facets.

An advanced laser structure has recently been noted in which reflectivities of both cleaved facets are reduced and the phase of the grating is discontinuous at the cavity center (for example, a phase-shift corresponding to 1/4 of guided wavelength λ). The DFB laser with such a structure has a great difference in threshold gain between the lasing longitudinal mode and the other modes. This type of DFB lasers therefore are remarkably advantageous to a single longitudinal mode operation. This laser however has a problem of spatial holeburning along its axis direction (Soda et al., "Stability in Single Longitudinal Mode Operation in GaInAsP/InP Phase-Adjusted DFB Lasers," IEEE JOURNAL OF QUANTUM ELECTRONICS, Vol. QE-23, No. 6, June, 1987). More specifically, when a normalized coupling coefficient κ L is more than 1.25, the power of guided waves concentrate at a position of the λ/4 phase-shift. The optical intensity profile along the axial direction causes a distribution of the carrier density in an active layer. The refractive index of an optical waveguide is distributed, corresponding to the distribution of the carrier density profile. The variation in the refractive index reduces a large gain difference, Δ α between longitudinal modes and thus greatly degrades the single longitudinal mode behavior.

The holeburning also causes the following disadvantage. If the refractive index of a region of the waveguide abruptly changes, the guided mode cannot efficiently be transformed and a part of light energy is radiated as a radiation mode outside the optical waveguide. The beams of radiation mode then interferes with an output light beam emitted from an output facet. A ripple is formed by the interference in the output radiation pattern, namely, a far field pattern (FFP). Therefore, the output light beam cannot efficiently be coupled with other optical components.

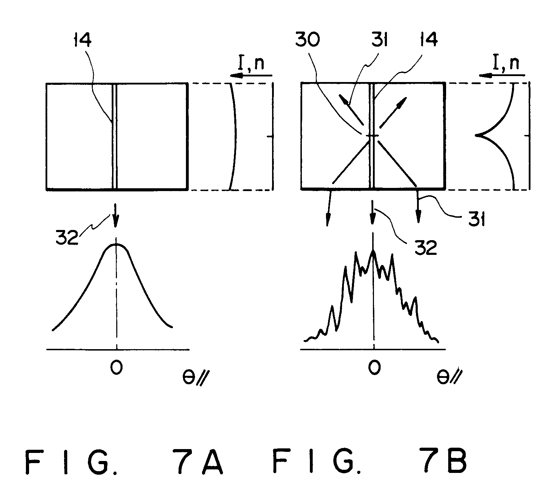

Figs. 7A and 7B are plan views of a conventional laser and views showing the FFP (= ϑ //) of the output light beam. In Figs. 7A and 7B, ϑ // indicates a full angle at half maximum in the horizontal direction of the FFP, and the optical intensity profiles (I) of guided wave in the cavity direction are shown on the right of the plan views of the laser.

Fig. 7A shows a Fabry-Perot type semiconductor laser. In this laser, the optical intensity profile I is relatively smooth and thus an undesired interference does not occur between the output light beam and radiation mode. The FFP (ϑ //) therefore has an ideal shape without large ripples.

Fig. 7B shows a λ/4 phase shifted type DFB laser. In this laser, the guided waves concentrate at a λ/4 phase shifted position 30 (I). The irregularity of optical intensity profile along the axial direction varies the carrier density in the active layer. As described above, in a portion of the optical waveguide where its refractive index greatly changes, the guided mode cannot efficiently be transformed and part of optical energy is radiated as a radiation mode outside the guiding layer. The FFP (ϑ //) is degraded by an interference between a radiation mode 31 and an output beam 32, as shown in Fig. 7B.

Not only the λ/4 phase shift type DFB laser but also a usual DFB laser has a drawback wherein the FFP of an output light beam of the laser is easily degraded ordered by a slight variation in refractive index.

US-4,282,494 shows a stripe geometry laser with optical obstacle regions in the vicinity of a window region formed between the reflective ends and the ends of the active region, to suppress higher order modes in horizontal transverse oscillations and thus stabilize and concentrate the main output beam.

It is accordingly an object of the present invention to provide a semiconductor laser which overcomes the above-described drawback of the conventional laser and emits a laser beam having a smooth FFP with good reproductivity.

According to the present invention there is provided a semiconductor laser comprising:
a semiconductor substrate transparent to an oscillation light beam;
a laser stripe through which an electric current flows, including an active layer, a guiding layer formed on said semiconductor substrate, and a diffraction grating formed along said guiding layer;
a phase shifted portion formed at a halfway point of said diffraction grating;
a semiconductor peripheral region formed so as to cover both sides of said laser stripe on said semiconductor substrate, said semiconductor peripheral region being transparent to an oscillation light beam; and
interrupting means for interrupting a radiation mode light beam radiated from said phase shifted portion to said semiconductor peripheral region, said interrupting means being located near both sides of the emission end of said laser stripe and in said semiconductor peripheral region so as not to interrupt an output light beam, and being formed by digging said semiconductor peripheral region and said semiconductor substrate to a greater depth than said laser stripe.

In other words, the above object is attained by the following method. Scoop regions each having a predetermined shape or holes each having a predetermined shape are formed more deeply than the level of the laser stripe, in the peripheral region and the semiconductor substrate including the emission facets, or in the peripheral region and the semiconductor substrate at a predetermined distance away from one or both of the emission facets of the laser.

Since the radiation mode light beam generated in the halfway point of the guiding layer is reflected and scattered by the scoop regions or holes, it does not reach the emission facets. The radiation mode light beam does not therefore interfere with an output beam and a far field pattern is thus smooth. This advantage will be greater especially when the present invention is applied to a single-mode DFB laser.

The semiconductor laser according to the present invention prevents an interference between the radiation mode emitted from a portion of the guiding layer whose refractive index is changed and the light beam emitted from the emission facets to form a uniform far field pattern. The manufacturing method of the semiconductor laser is relatively easy.

Since the emitted light beam can efficiently be coupled with other optical components, it has the great advantage of its application.

This invention can be more fully understood from the following detailed description when taken in conjunction with the accompanying drawings, in which:
Fig. 1 is a perspective view showing a λ/4 phase shifted type GaInAsP/InP buried heterostructure (BH-structure) DFB laser to which the present invention has not been applied;
Fig. 2 is a cross-sectional view taken along line II - II of Fig. 1;
Fig. 3 is a perspective view showing a GaInAsP/InP BH-structure DFB laser according to a first embodiment of the present invention;
Fig. 4 is a BH-structure DFB laser according to a second embodiment of the present invention;
Fig. 5 is a perspective view showing a BH-structure DFB laser according to a third embodiment of the present invention;
Fig. 6 is a plan view of the laser shown in Fig. 4, a view showing, under the plan view, a far field pattern (FFP : ϑ //) of light beam output from the laser, and a view showing, on the right of the plan view, an optical intensity profile (I) or a refractive index profile (n) of guided waves in the direction of a cavity; and
Figs. 7A and 7B are plan views showing conventional lasers, views showing, under the plan views, far field patterns (FFP : ϑ //) of light beams output from the lasers, and views showing, on the right of the plan views, optical intensity profiles (I) or refractive index profiles (n) of guided waves in the direction of a cavity.

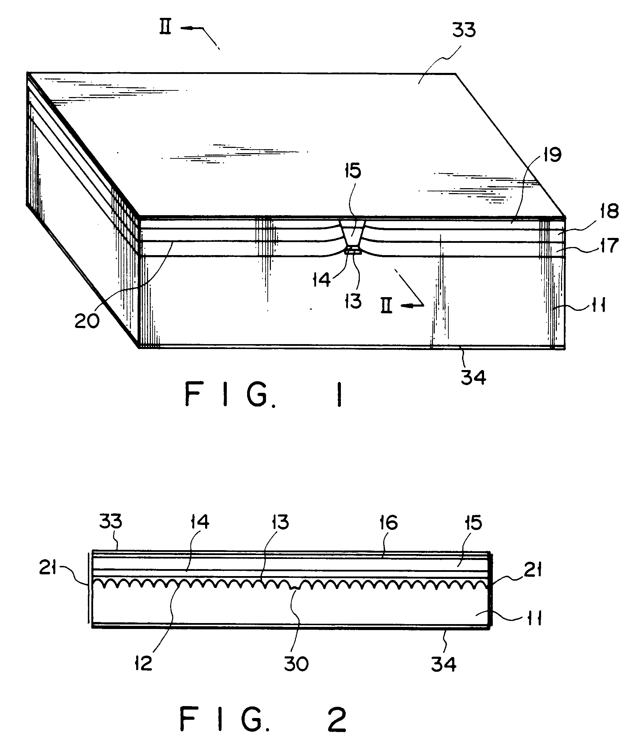

Fig. 1 is a perspective view showing a λ/4 phase shifted type GaInAsP/InP buried heterostructure (BH-structure) DFB laser, and Fig. 2 is a cross-sectional view showing a laser stripe and taken along line II - II of Fig. 1. This laser is an unimproved one to which the present invention has not been applied.

The laser is manufactured as follows. A first-order grating 12 is formed on an n-type InP substrate 11 by a two-beam interference exposure method. An n-type GaInAsP guiding layer 13 (composition: in which the band gap corresponds to a wavelength of 1.3»m), an undoped GaInAsP active layer 14 (composition: λ = 1.55»m), a p-type InP cladding layer 15, and a p⁺-type GaInAsP ohmic contact layer 16 (composition: λ = 1.15»m) are successively grown on the first-order grating 12. A mesa-stripe portion is then formed by etching, and a p-type InP layer 17, an n-type InP layer 18 and an undoped GaInAsP cap layer 19 (composition: λ = 1.15»m) are continuously grown around the mesa-stripe portion and the mesa-stripe portion is buried, resulting in a buried heterostructure (BH-structure). Since current is blocked by a reverse-biased pn junction 20 in a region around the buried mesa-stripe portion, the current is efficiently injected only into the stripe-shape active layer 14.

To oscillate in a single longitudinal mode, the refractive index of both cleavage facets is lowered by an anti-reflection (AR) coat 21, and a λ/4 phase shifted portion 30 is formed in the cavity center. In Figs. 1 and 2, reference numerals 33 and 34 denote a p-side electrode and an n-side electrode, respectively.

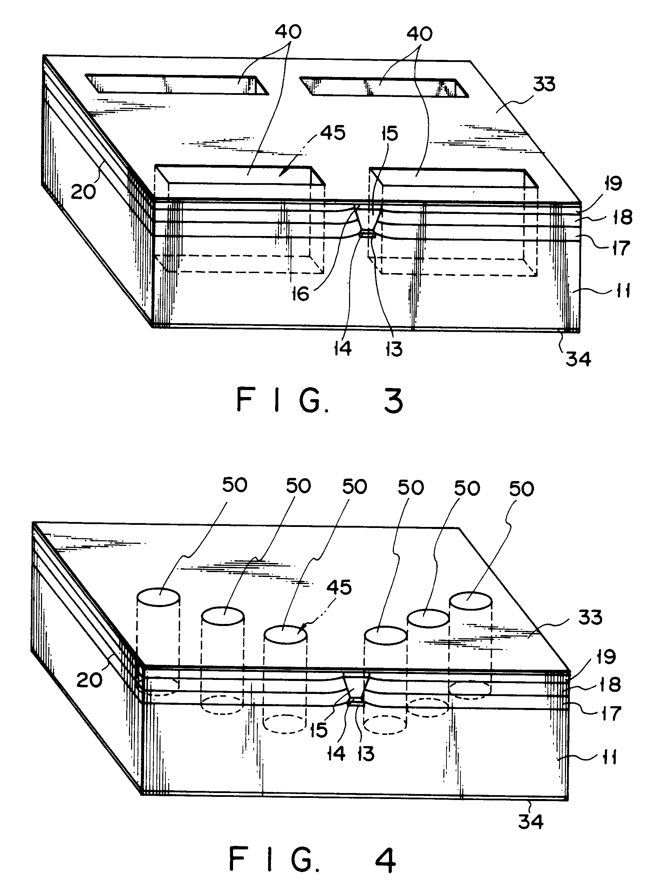

Fig. 3 is a perspective view showing a laser according to a first embodiment of the present invention which is applied to the GaInAsP/InP BH-structure DFB laser shown in Figs. 1 and 2. The basic structure of the laser corresponding to that of the laser shown in Fig. 1 is achieved by the same method as described above.

Grooves 40 are formed perpendicularly to the active layer 14 in the vicinity of facets of the laser. The grooves can be patterned by photoresist-exposure procedure and digging the layer and substrate more deeply than the guiding layer 13 by ion milling. The grooves can be also formed by the well-known method such as reactive ion etching (RIE).

Beams of radiation mode generated in a halfway point of the guiding layer 13 is reflected by the grooves and does not reach the output facet of the laser. The radiation mode does not interfere with an output beam from the laser and therefore the FFP can be kept smooth.

Fig. 4 is a perspective view showing a laser according to a second embodiment of the present invention which is applied to the laser shown in Figs. 1 and 2. The basic structure of the laser corresponding to that of the laser shown in Fig. 1 is achieved by the same method as described above.

In the second embodiment, a plurality of columnar holes 50 is formed in the vicinity of the output facet. The holes can be also formed by the photoresist procedure deeply digging the layers and substrate by the ion milling.

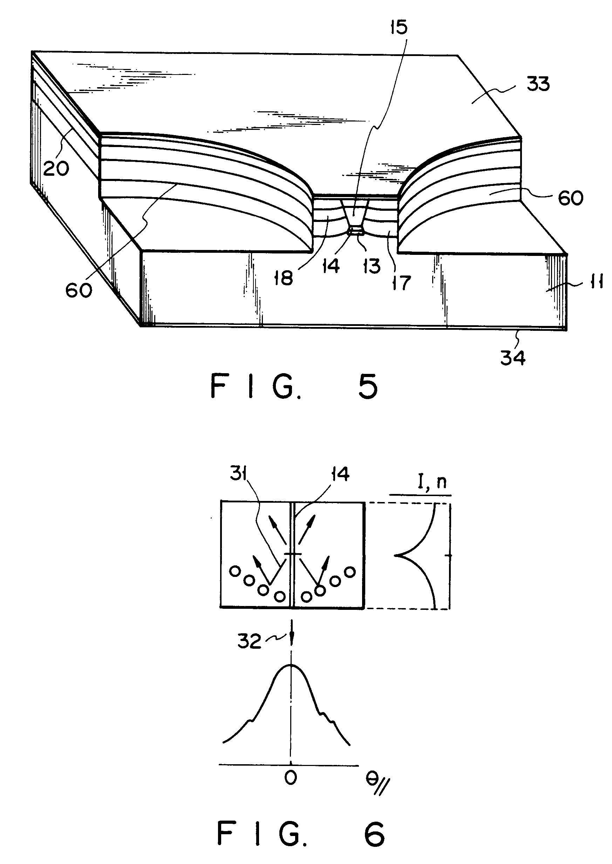

Beams of radiation mode generated in a halfway point of the guiding layer is reflected and scattered by the holes 50 and does not reach the output facet. The radiation mode does not interfere with an output beam 32 from the laser and therefore the FFP is kept smooth, which is shown in Fig. 6. The holes are so arranged that the radiation mode 31 is effectively scattered.

In the first and second embodiments, the grooves 40 or holes 50 are filled with polyimide 45 or the like serving as light absorbing material, as indicated by arrows in Figs. 3 and 4. The radiation mode is not only irregularly reflected by the grooves 40 or holes 50, but also absorbed by the polyimide with which they are filled. The radiation mode light beam is reliably prevented from reaching the output facet.

Fig. 5 is a perspective view showing a laser according to a third embodiment which is applied to the laser shown in Figs. 1 and 2. The basic structure of the laser corresponding to that of the laser shown in Fig. 1 is achieved by the same method as described above.

In the third embodiment, peripheral region near the output facet are removed, together with the facet, itself, by digging the layers and substrate by ion milling, as shown in Fig. 5. The curve of the removed region 60 is so designed that the radiation mode light beam is effectively reflected and it is not emitted forward. Thus the radiation mode does not interfere with the output beam 32 and a far field pattern (FFP) is uniformly formed as shown in Fig. 6.

## Claims

1. A semiconductor laser comprising:
a semiconductor substrate (11) transparent to an oscillation light beam;
a laser stripe through which an electric current flows, including an active layer (14), a guiding layer (13) formed on said semiconductor substrate, and a diffraction grating (12) formed along said guiding layer;
a phase shifted portion (30) formed at a halfway point of said diffraction grating;
a semiconductor peripheral region (17,18,19) formed so as to cover both sides of said laser stripe on said semiconductor substrate, said semiconductor peripheral region being transparent to an oscillation light beam; and
interrupting means (40,50,60) for interrupting a radiation mode light beam (31) radiated from said phase shifted portion to said semiconductor peripheral region, said interrupting means being located near both sides of the emission end of said laser stripe and in said semiconductor peripheral region so as not to interrupt an output light beam (32), and being formed by digging said semiconductor peripheral region and said semiconductor substrate to a greater depth than said laser stripe.

2. The semiconductor laser according to claim 1, characterized in that said interrupting means comprises rectangular grooves (40) formed by digging said semiconductor peripheral region (17, 18, 19) and said semiconductor substrate (11) near both sides of the emission end of said laser stripe.

3. The semiconductor laser according to claim 2, characterized in that said grooves (40) are arranged near both ends of said laser stripe.

4. The semiconductor laser according to claim 1, characterized in that said interrupting means comprises round holes (50) formed by digging said semiconductor peripheral region (17, 18, 19) and said semiconductor substrate (11) near both sides of the emission end of said laser stripe.

5. The semiconductor laser according to claim 1, characterized in that said interrupting means comprises scoop regions formed by removing said semiconductor peripheral region (17, 18, 19) and said semiconductor substrate (11) on both sides of the emission end of said laser stripe.

6. The semiconductor laser according to claim 2, characterized in that said grooves (40) are filled with a light absorbing material.

7. The semiconductor laser according to claim 4, characterized in that said holes (50) are filled with a light absorbing material.

8. The semiconductor laser according to Claim 1 wherein said interrupting means is located in said semiconductor peripheral region between said emission end and said phase shifted portion.

9. The semiconductor laser according to claim 1, characterized in that said semiconductor laser is a distributed feedback semiconductor laser for applying optical feedback by use of said diffraction grating (12).

10. The semiconductor laser according to Claim 1, wherein both ends of said laser stripe are cleavage facets aligned with cleavage facets of said semiconductor peripheral region and semiconductor substrate.

11. The semiconductor laser according to Claim 1 wherein coats (21) having a low reflectivity are provided on said cleavage facets.

## Patentansprüche

1. Halbleiterlaser, aufweisend:
- ein Halbleitersubstrat (11), das für einen Schwingungslichtstrahl transparent ist;
- einen Laserstreifen, durch den ein elektrischer Strom fließt und der eine aktive Schicht (14), eine auf dem Halbleitersubstrat gebildete führende Schicht (13) und ein entlang der führenden Schicht gebildetes Beugungsgitter (12) umfaßt;
- einen phasenverschobenen Abschnitt (30), der an einem Punkt in der Hälfte des Beugungsgitters gebildet ist;
- einen peripheren Halbleiterbereich (17, 18, 19), der so ausgebildet ist, daß er beide Seiten des Laserstreifens auf dem Halbleitersubstrat bedeckt, wobei der periphere Halbleiterbereich für einen Schwingungslichtstrahl transparent ist; und
- eine Unterbrechungseinrichtung (40, 50, 60) zum Unterbrechen eines Strahlenmodus-Lichtstrahls (31), der von dem phasenverschobenen Abschnitt auf den peripheren Halbleiterbereich gestrahlt wird, wobei die Unterbrechungseinrichtung in der Nähe beider Seiten des Emissionsendes des Laserstreifens sowie im peripheren Halbleiterbereich plaziert ist, so daß sie einen ausgegebenen Ausgangslichtstrahl (32) nicht unterbricht und durch Abtragen des peripheren Halbleiterbereichs und des Halbleitersubstrats auf eine größere Tiefe als dem Laserstreifen gebildet ist.

2. Halbleiterlaser nach Anspruch 1,
dadurch **gekennzeichnet**, daß die Unterbrechungseinrichtung rechteckige Nuten (40) umfaßt, die durch Abtragen des peripheren Halbleiterbereichs (17, 18, 19) und des Halbleitersubstrats (11) in der Nähe beider Seiten des Emissionsendes des Laserstreifens gebildet sind.

3. Halbleiterlaser nach Anspruch 2,
dadurch **gekennzeichnet**, daß die Nuten (40) in der Nähe beider Enden des Laserstreifens angeordnet sind.

4. Halbleiterlaser nach Anspruch 1,
dadurch **gekennzeichnet**, daß die Unterbrechungseinrichtung runde Löcher (50) umfaßt, die durch Abtragen des peripheren Halbleiterbereichs (17, 18, 19) und des Halbleitersubstrats (11) in der Nähe beider Seiten des Emissionsendes des Laserstreifens gebildet sind.

5. Halbleiterlaser nach Anspruch 1,
dadurch **gekennzeichnet**, daß die Unterbrechungseinrichtung Abtragungsbereiche aufweist, die durch Beseitigen des peripheren Halbleiterbereiches (17, 18, 19) sowie des Halbleitersubstrats (11) auf beiden Seiten des Emissionsendes des Laserstreifens gebildet sind.

6. Halbleiterlaser nach Anspruch 2,
dadurch **gekennzeichnet**, daß die Nuten (40) mit einem lichtabsorbierenden Material gefüllt sind.

7. Halbleiterlaser nach Anspruch 4,
dadurch **gekennzeichnet**, daß die Löcher (50) mit einem lichtabsorbierenden Material gefüllt sind.

8. Halbleiterlaser nach Anspruch 1,
bei dem die Unterbrechungseinrichtung im peripheren Halbleiterbereich zwischen dem Emissionsende und dem phasenverschobenen Abschnitt plaziert ist.

9. Halbleiterlaser nach Anspruch 1,
dadurch **gekennzeichnet**, daß der Halbleiterlaser ein Laser mit verteilter Rückkopplung zum Ausüben einer optischen Rückkopplung durch Verwendung des Beugungsgitters (12) ist.

10. Halbleiterlaser nach Anspruch 1,
bei dem beide Enden Spaltfacetten sind, die mit Spaltfacetten des peripheren Halbleiterbereiches, welche in einer Flucht mit Spaltfacetten des peripheren Halbleiterbereichs und des Halbleitersubstrats liegen.

11. Halbleiterlaser nach Anspruch 1,
bei dem Überzüge (21) mit niedrigem Reflektionsvermögen auf den Spaltfacetten vorgesehen sind.

## Revendications

1. Laser à semi-conducteur comprenant :
un substrat semi-conducteur (11) transparent à un faisceau lumineux d'oscillation ;
une bande laser dans laquelle s'écoule un courant électrique, incluant une couche active (14), une couche de guidage (13) formée sur ledit substrat semi-conducteur et un réseau de diffraction (12) formé le long de ladite couche de guidage ;
une partie déphasée (30) formée en un point situé à mi-chemin dudit réseau de diffraction ;
une région semi-conductrice périphérique (17, 18, 19) formée de manière à recouvrir les deux côtés de ladite bande laser sur ledit substrat semi-conducteur, ladite région semi-conductrice périphérique étant transparente à un faisceau lumineux d'oscillation ; et
un moyen d'interruption (40, 50, 60) pour interrompre un faisceau lumineux en mode rayonnement (31) émis à partir de ladite partie déphasée vers ladite région semi-conductrice périphérique, ledit moyen d'interruption étant situé auprès, de chaque côté, de l'extrémité d'émission de ladite bande laser et dans ladite région semi-conductrice périphérique de façon à ne pas interrompre un faisceau lumineux de sortie (32), et étant formé en creusant ladite région semi-conductrice périphérique et ledit substrat semi-conducteur jusqu'à une profondeur plus grande que ladite bande laser.

2. Laser à semi-conducteur selon la revendication 1, caractérisé en ce que ledit moyen d'interruption comprend des rainures rectangulaires (40) formées en creusant ladite région semi-conductrice périphérique (17, 18, 19) et ledit substrat semiconducteur (11) auprès, de chaque côté, de l'extrémité d'émission de ladite bande laser.

3. Laser à semi-conducteur selon la revendication 2, caractérisé en ce que lesdites rainures (40) sont disposées à proximité des deux extrémités de ladite bande laser.

4. Laser à semi-conducteur selon la revendication 1, caractérisé en ce que ledit moyen d'interruption comprend des trous ronds (50) formés en creusant ladite région semi-conductrice périphérique (17, 18, 19) et ledit substrat semi-conducteur (11) auprès, de chaque côté, de l'extrémité d'émission de ladite bande laser.

5. Laser à semi-conducteur selon la revendication 1, caractérisé en ce que ledit moyen d'interruption comprend des régions formées par suppression de ladite région semi-conductrice périphérique (17, 18, 19) et dudit substrat semiconducteur (11) de chaque côté de l'extrémité d'émission de ladite bande laser.

6. Laser à semi-conducteur selon la revendication 2, caractérisé en ce que lesdites rainures (40) sont remplies d'une matière absorbant la lumière.

7. Laser à semi-conducteur selon la revendication 4, caractérisé en ce que lesdits trous (50) sont remplis d'une matière absorbant la lumière.

8. Laser à semi-conducteur selon la revendication 1, dans lequel ledit moyen d'interruption est situé dans ladite région semi-conductrice périphérique entre ladite extrémité d'émission et ladite partie déphasée.

9. Laser à semi-conducteur selon la revendication 1, caractérisé en ce que ledit laser à semi-conducteur est un laser à semi-conducteur à contre-réaction répartie pour application d'une contre-réaction optique par utilisation dudit réseau de diffraction (12).

10. Laser à semi-conducteur selon la revendication 1, dans lequel les deux extrémités de ladite bande laser sont des facettes obtenues par clivage alignées avec des facettes obtenues par clivage de ladite région semi-conductrice périphérique et du substrat semi-conducteur.

11. Laser à semi-conducteur selon la revendication 1, dans lequel des revêtements (21) ayant une faible réflectivité sont disposés sur lesdites facettes obtenues par clivage.
